(19) Europäisches Patentamt European Patent Office Office européen des brevets

(11) **EP 4 239 553 A1**

(12) **EUROPEAN PATENT APPLICATION**

(43) Date of publication:
**06.09.2023 Bulletin 2023/36**

(21) Application number: **22211113.0**

(22) Date of filing: **02.12.2022**

(51) International Patent Classification (IPC):
*G06Q 10/30* (2023.01)    *B60L 58/16* (2019.01)
*G01R 31/392* (2019.01)    *G06Q 50/06* (2012.01)
*H01M 10/48* (2006.01)

(52) Cooperative Patent Classification (CPC):
**G06Q 50/06; B60L 58/16; G01R 31/392;
G06Q 10/30; H01M 10/48;** H01M 10/425;
H01M 10/54

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **02.03.2022 JP 2022031932**

(71) Applicant: **TOYOTA JIDOSHA KABUSHIKI
KAISHA
Aichi-Ken 471-8571 (JP)**

(72) Inventors:
• **KOMADA, Atsushi
Toyota-shi, Aichi-ken,, 471-8571 (JP)**

• **OGASAWARA, Mitsuru
Toyota-shi, Aichi-ken,, 471-8571 (JP)**
• **ISHII, Masahiko
Toyota-shi, Aichi-ken,, 471-8571 (JP)**
• **ASANO, Hidetaka
Toyota-shi, Aichi-ken,, 471-8571 (JP)**
• **ISHII, Tomokazu
Toyota-shi, Aichi-ken,, 471-8571 (JP)**
• **HETSUGI, Koji
Toyota-shi, Aichi-ken,, 471-8571 (JP)**
• **YONEKAWA, Kosuke
Toyota-shi, Aichi-ken,, 471-8571 (JP)**
• **JIKUHARA, Yoshikazu
Toyota-shi, Aichi-ken,, 471-8571 (JP)**

(74) Representative: **Winter, Brandl - Partnerschaft
mbB
Alois-Steinecker-Straße 22
85354 Freising (DE)**

(54) **MANAGEMENT DEVICE, MANAGEMENT METHOD, AND MANAGEMENT SYSTEM**

(57)    A management device (2) includes a storage (27) configured to store an amount of CO2 emissions emitted by manufacturing a secondary battery, and a controller (21; 21A) configured to, when the secondary battery is recycled by a business operator who recycles the secondary battery, apportion the amount of CO2 emissions with the business operator according to a degree of deterioration of the secondary battery at a time of being recycled.

FIG. 4

## Description

BACKGROUND OF THE INVENTION

1. Field of the Invention

The present disclosure relates to a management device, a management method, and a management system for managing the amount of carbon dioxide ($CO_2$) emissions emitted by manufacturing secondary batteries.

2. Description of Related Art

With the growing awareness of environmental issues, there is growing concern about the amount of $CO_2$ emissions emitted to manufacture products distributed on the market. Therefore, in some cases, companies calculate and manage the amount of $CO_2$ emissions emitted to manufacture products. For example, Japanese Unexamined Patent Application Publication No. 2016-126372 (JP 2016-126372 A) discloses a method of calculating the amount of $CO_2$ emissions in the transportation process of products (including materials and parts).

SUMMARY OF THE INVENTION

Vehicles equipped with secondary batteries for traveling are rapidly becoming popular. The secondary batteries mounted on the vehicles may be recycled (for example, reused or rebuilt) by recycling business operators. In this case, the recycling business operators can operate the business using recycled secondary batteries without any burden of the amount of $CO_2$ emissions emitted to manufacture the secondary batteries (the amount of $CO_2$ emissions of the secondary batteries). Unfairness arises in terms of the burden of the amount of $CO_2$ emissions between the automobile manufacturer bearing the amount of $CO_2$ emissions of the secondary batteries and the recycling business operators.

The present disclosure provides a management device, a management method, and a management system, which can appropriately apportion the amount of $CO_2$ emissions emitted by manufacturing secondary batteries to a business operator who recycles secondary batteries.

A first aspect of the present disclosure relates to a management device including a storage and a controller. The storage is configured to store an amount of $CO_2$ emissions emitted by manufacturing a secondary battery. The controller is configured to, when the secondary battery is recycled by a business operator who recycles the secondary battery, apportion the amount of $CO_2$ emissions with the business operator according to a degree of deterioration of the secondary battery at a time of being recycled.

According to the first aspect, when the secondary battery is recycled, the amount of $CO_2$ emissions is apportioned with the business operator who recycles the secondary battery according to the degree of deterioration of the secondary battery at the time of being recycled. By apportioning the amount of $CO_2$ emissions according to the degree of deterioration, the business operator can be made to bear an appropriate amount of $CO_2$ emissions.

In the first aspect of the present disclosure, the management device may further include a communicator. The secondary battery may be mounted on a moving body. The communicator may be configured to communicate with the moving body, and the controller may be configured to acquire information about the secondary battery from the moving body through the communicator, and calculate the degree of deterioration by using the information when the secondary battery is recycled.

According to the first aspect, the controller of the management device calculates the degree of deterioration of the secondary battery by using the information about the secondary battery acquired from the moving body. The controller can appropriately apportion the amount of $CO_2$ emissions with the business operator according to the calculated degree of deterioration.

In the first aspect of the present disclosure, the management device may further include a communicator. The secondary battery may be mounted on a moving body. The communicator may be configured to communicate with the moving body, and the controller may be configured to, when the secondary battery is recycled, acquire the degree of deterioration from the moving body through the communicator.

According to the first aspect, the controller of the management device acquires the degree of deterioration from the moving body. The controller can appropriately apportion the amount of $CO_2$ emissions with the business operator according to the acquired degree of deterioration.

In the first aspect of the present disclosure, the management device may further include a communicator configured to communicate with a management device of the business operator. The controller may be configured to, when the secondary battery is recycled, acquire the degree of deterioration from the management device of the business operator through the communicator.

According to the first aspect, the controller of the management device acquires the degree of deterioration from the management device of the business operator. The controller can appropriately apportion the amount of $CO_2$ emissions with the business operator according to the acquired degree of deterioration.

In the first aspect of the present disclosure, the management device may further include a communicator configured to communicate with a management device of the business operator. The controller may be configured to, when the secondary battery is recycled, acquire a burden share of the amount of $CO_2$ emissions corresponding to the degree of deterioration from the management device of the business operator through the communicator.

According to the first aspect, the controller of the management device acquires the burden share of the amount of $CO_2$ emissions corresponding to the degree of deterioration from the management device of the business operator. For example, the controller can update the amount of $CO_2$ emissions stored in the storage based on the acquired burden share. Therefore, it is possible to appropriately apportion the amount of $CO_2$ emissions with the business operator.

In the first aspect of the present disclosure, the degree of deterioration may be a capacity maintenance rate of the secondary battery. According to the first aspect, the amount of $CO_2$ emissions can be apportioned with the business operator according to the capacity maintenance rate, and thus the business operator can be made to bear an appropriate amount of $CO_2$ emissions.

In the first aspect of the present disclosure, the controller may be configured to increase a burden share of the amount of $CO_2$ emissions of the business operator as the capacity maintenance rate when the secondary battery is recycled is higher.

According to the first aspect, the higher the capacity maintenance rate of the secondary battery, the greater the burden share of the amount of $CO_2$ emissions on the business operator, and thus the business operator can be made to bear an appropriate amount of $CO_2$ emissions.

A second aspect of the present disclosure relates to a management method. The management method includes storing an amount of $CO_2$ emissions emitted by manufacturing a secondary battery, and when the secondary battery is recycled by a business operator who recycles the secondary battery, apportioning the amount of $CO_2$ emissions with the business operator according to a degree of deterioration of the secondary battery at the time of being recycled.

According to the second aspect, when the secondary battery is recycled, the amount of $CO_2$ emissions is apportioned with the business operator who recycles the secondary battery according to the degree of deterioration of the secondary battery at the time of being recycled. By apportioning the amount of $CO_2$ emissions according to the degree of deterioration, the business operator can be made to bear an appropriate amount of $CO_2$ emissions.

A third aspect of the present disclosure relates to a management system includes a first device configured to manage an amount of $CO_2$ emissions emitted by manufacturing a secondary battery and a second device of a business operator who recycles the secondary battery. The first device is configured to, when the secondary battery is recycled, update the amount of $CO_2$ emissions according to a degree of deterioration of the secondary battery at the time of being recycled, and the second device is configured to manage the amount of $CO_2$ emis-

sions corresponding to the degree of deterioration.

According to the third aspect, the amount of $CO_2$ emissions is apportioned between the first device and the second device according to the degree of deterioration of the secondary battery. Therefore, the amount of $CO_2$ emissions can be appropriately apportioned between the first device and the second device. Therefore, the business operator can be made to bear an appropriate amount of $CO_2$ emissions.

According to the present disclosure, it is possible to appropriately apportion the amount of $CO_2$ emissions emitted by manufacturing secondary batteries with a business operator who recycles secondary batteries.

BRIEF DESCRIPTION OF THE DRAWINGS

Features, advantages, and technical and industrial significance of exemplary embodiments of the invention will be described below with reference to the accompanying drawings, in which like signs denote like elements, and wherein:

FIG. 1 is an overall configuration diagram of a management system according to Embodiment 1;
FIG. 2 is a diagram for describing an example of the amount of $CO_2$ emissions of a vehicle that is stored in a database;
FIG. 3 is a functional block diagram of a control device of a management device and a control device of another management device;
FIG. 4 is a flowchart showing a procedure of a process executed at the time when a battery is recycled;
FIG. 5 is a flowchart showing a detailed process for S21 in FIG. 4;
FIG. 6 is a flowchart showing a detailed process for S21 in FIG. 4, according to Modification Example 1;
FIG. 7 is a functional block diagram of a control device of a management device and a control device of another management device according to Embodiment 2;
FIG. 8 is a flowchart showing a procedure of a process executed at the time when a battery is recycled, according to Embodiment 2; and
FIG. 9 is a flowchart showing a procedure of a process executed at the time when a battery is recycled, according to Modification Example 3.

DETAILED DESCRIPTION OF EMBODIMENTS

Hereinafter, embodiments of the present disclosure will be described in detail with reference to the drawings. In the drawings, the same or corresponding elements are denoted by the same reference numerals and descriptions thereof will not be repeated.

Embodiment 1

Configuration

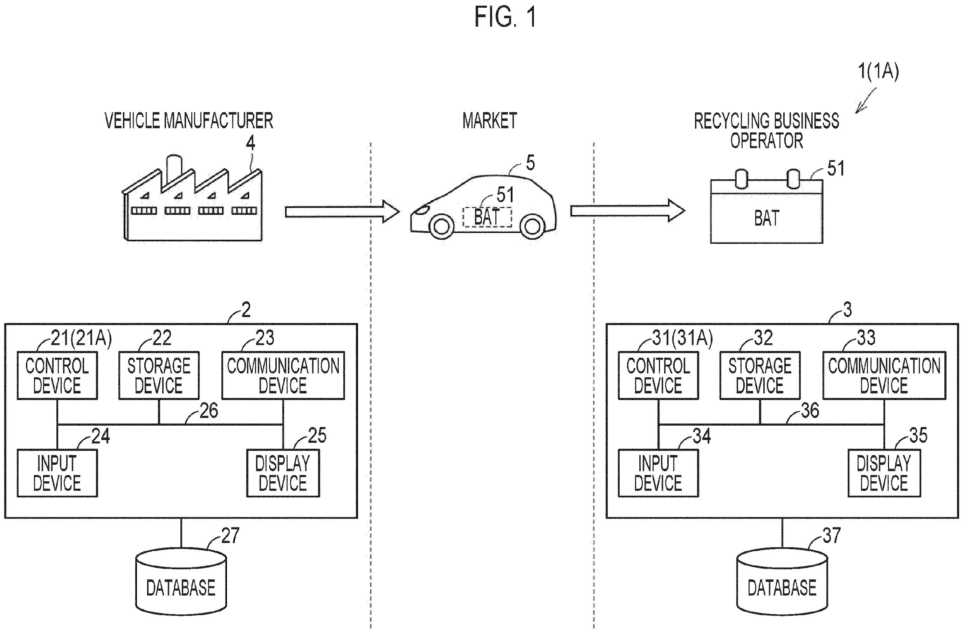

FIG. 1 is an overall configuration diagram of a management system 1 according to Embodiment 1. The management system 1 is a system for managing the amount of $CO_2$ emissions emitted from battery manufacturing. The management system 1 includes a management device 2 belonging to an automobile manufacturer (vehicle manufacturer) and a management device 3 belonging to a battery recycling business operator.

The vehicle manufacturer supplies a vehicle 5 manufactured at a factory 4 (including the manufacturer's own factory and a cooperating company's factory) to the market through dealers and other sales companies. The vehicle 5 is a battery electric vehicle equipped with a battery 51. Note that the vehicle 5 may be any vehicle equipped with the battery 51, and is not limited to the battery electric vehicle. The vehicle 5 may be, for example, a hybrid electric vehicle, a plug-in hybrid electric vehicle, or a fuel cell electric vehicle.

The battery 51 is mounted on the vehicle 5 as, for example, a driving electric power source (that is, power source). The battery 51 includes a plurality of stacked cells. The cell is, for example, a secondary cell, such as a nickel-metal hydride cell or a lithium-ion cell. Further, the cell may be a cell having a liquid electrolyte between a positive electrode and a negative electrode, or a cell having a solid electrolyte (all-solid-state cell). A "battery ID" for identifying the battery is attached to the battery 51. Further, a "cell ID" for identifying the cell may be attached to each of the cells.

The management device 2 of the vehicle manufacturer manages the amount of $CO_2$ emissions emitted by manufacturing the vehicle 5. The amount of $CO_2$ emissions emitted by manufacturing the vehicle 5 includes the amount of $CO_2$ emissions emitted by manufacturing each of parts (including materials) that constitutes the vehicle 5, and the amount of $CO_2$ emissions emitted from the transportation or the like of each of the parts (including materials). A vehicle manufacturer purchases each of the parts that constitutes the vehicle 5 from an upstream company in a supply chain. Together with the delivered part, the vehicle manufacturer receives reports from the upstream company on the amount of $CO_2$ emissions emitted by manufacturing the part and the amount of $CO_2$ emissions emitted by the transportation of the part or the like. The management device 2 calculates the amount of $CO_2$ emissions emitted by manufacturing the vehicle 5 (hereinafter also referred to as "$CO_2$ of the vehicle 5"), including, for example, the amount of $CO_2$ emissions received from each upstream company and the amount of $CO_2$ emissions emitted to complete the vehicle 5 using the parts. In addition, hereinafter, the amount of $CO_2$ emissions emitted by manufacturing the parts (including materials) and the amount of $CO_2$ emissions emitted from the transportation of the parts (including materials) are collectively referred to as "the amount of $CO_2$ emissions of parts".

The management device 2 includes a control device 21, a storage device 22, a communication device 23, an input device 24, and a display device 25. The control device 21, storage device 22, communication device 23, input device 24 and display device 25 are connected to a bus 26. A database 27 is communicably connected to the management device 2. Note that the management device 2 is an example of a "first device".

The control device 21 is built with, for example, an integrated circuit including a central processing unit (CPU). The control device 21 executes various programs stored in the storage device 22. Various programs include an operating system and the like. The storage device 22 may include, for example, a read only memory (ROM) that stores the various programs, and a random access memory (RAM) that functions as a working memory and temporarily stores various data needed to execute the various programs. Note that the control device 21 is an example of a "controller".

The communication device 23 is configured to communicate with management device 3 and vehicle 5. Communication between communication device 23 and management device 3 and vehicle 5 is performed, for example, through the Internet. In addition, the communication device 23 is an example of a "communicator".

The input device 24 includes a device for inputting. The device for inputting is, for example, a mouse, a keyboard, a touch panel, and/or another device capable of accepting user operations.

The display device 25 includes a display. The display device 25 displays various images on the display according to a control signal from the control device 21. The display is, for example, a liquid crystal display, an organic electro luminescence (EL) display, or another display device.

The database 27 stores information according to a control signal from the management device 2 (control device 21). The control device 21 stores, in the database 27, the amount of $CO_2$ emissions of each of the parts that constitute the vehicle 5 (that is, the reported value received from the upstream company). The control device 21 stores, in the database 27, a value obtained by adding up the amounts of $CO_2$ emissions of each of the parts that constitute the vehicle 5 as the amount of $CO_2$ emissions of the vehicle 5. Note that the database 27 stores the amounts of $CO_2$ emissions of all vehicles supplied to the market by vehicle manufacturer, in addition to the vehicle 5. The database 27 can also be provided as a storage device within the management device 2. Note that the database 27 is an example of a "storage".

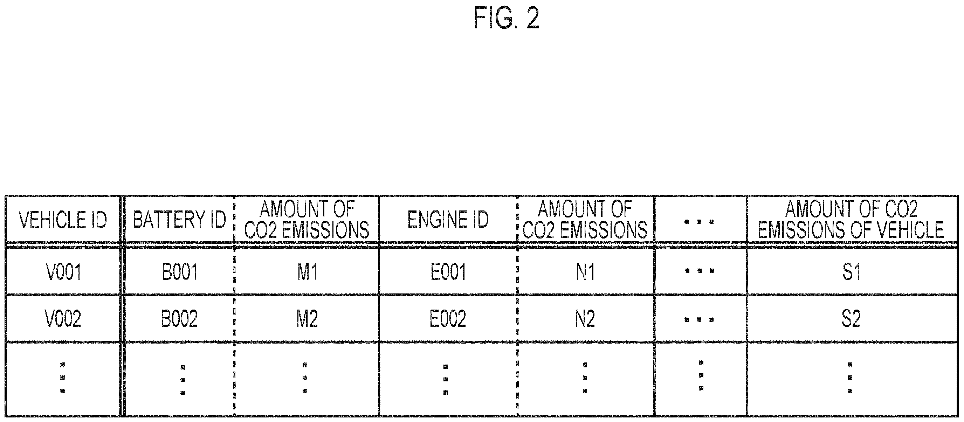

FIG. 2 is a diagram for describing an example of the amount of $CO_2$ emissions of a vehicle that is stored in the database 27. The amount of $CO_2$ emissions of the vehicle is stored for each vehicle ID. The vehicle ID is information for specifying a vehicle, and may be, for example, a vehicle identification number (VIN). The vehicle ID may be any information that can uniquely identify the vehicle, and may be other information. In the present embodiment, it is assumed that vehicle 5 has a vehicle ID of "V001".

FIG. 2 shows, as an example, a vehicle ID, a battery ID, the amount of $CO_2$ emissions associated with the battery ID (the amount of $CO_2$ emissions of the battery), an engine ID, the amount of $CO_2$ emissions associated with the engine ID (the amount of $CO_2$ emissions of an engine), and the amount of $CO_2$ emissions of the vehicle. For example, in the vehicle ID "V001", the battery 51 specified by the battery ID "B001", the amount of $CO_2$ emissions "M1" of the battery 51, the engine specified by the engine ID "E001", the amount of $CO_2$ emissions "N1" of the engine, and the amount of $CO_2$ emissions "SI" of the vehicle 5 are associated with each other. The sum of the amount of $CO_2$ emissions "M1" of the battery 51, the amount of $CO_2$ emissions "N1" of the engine, and the amount of $CO_2$ emissions of other parts (not shown) that constitutes the vehicle 5 is the amount of $CO_2$ emissions "SI" of the vehicle 5 specified by the vehicle ID "V001".

Referring back to FIG. 1, the vehicle manufacturer reports the amount of $CO_2$ emissions of the vehicle 5 stored in the database 27 to, for example, a government agency or a private agency when the vehicle manufacturer supplies the vehicle 5 to the market. For example, a tax may be imposed on the vehicle manufacturer depending on the amount of $CO_2$ emissions. The above-mentioned report is made through the communication device 23 by the control device 21 controlling each part in response to an input to the input device 24 by a manager of the management device 2 (e.g., an employee of the vehicle manufacturer) or the like. The report may be in a form that allows recognition of the amount of $CO_2$ emissions for each of the parts that constitutes the vehicle 5 (for example, the amount of $CO_2$ emissions of the battery 51).

After the vehicle 5 is supplied to the market, the management device 2 acquires information about the battery 51 (hereinafter also referred to as "battery information") from the vehicle 5 supplied to the market. Specifically, once the vehicle 5 is started, the control device 21 acquires the battery information from the vehicle 5 through the communication device 23 at every predetermined control cycle until the vehicle 5 enters a sleep state. The battery information includes information on the voltage of the battery 51 (battery voltage), information on current input/output to/from the battery 51 (battery current), and information on the temperature of the battery 51 (battery temperature). The control device 21 stores the battery information in the database 27 in association with the battery ID.

Among the parts that constitute the vehicle 5, there are parts that are highly likely to be taken out from the vehicle 5 and recycled later. An example of such a part is the battery 51. When the vehicle 5 is scrapped and so on after a predetermined number of years has passed since the distribution of the vehicle 5 in the market, the battery 51 is collected from the vehicle 5 by a recycling business operator, and the collected battery 51 is recycled. Battery recycling includes, for example, reusing and rebuilding.

Reuse refers to re-supplying (distributing) the battery 51 that has been collected (removed) from the vehicle 5 with the same function and performance at the time of the collection. The collected battery 51 is subjected to inspections needed, and the battery 51 that satisfies the requirements in the inspections are distributed on the market as reuse products.

Rebuilding is recovering or maintaining the function and performance of the battery 51 collected from the vehicle 5 and changing the structure and/or performance of the battery 51 and supplying the battery 51. The collected battery 51 is once disassembled into cells. Then, among the cells from the disassembling of the battery 51, usable cells (cells that become usable after recovery of performance may be used) are combined to manufacture a new battery.

A recycling business operator according to the present embodiment is a business operator that collects the battery 51 from the vehicle 5 and reuses the collected battery 51. Note that the recycling business operator is not limited to a business operator that performs reuse, and may be any business operator that performs at least one of reuse or rebuild. The recycling business operator may be a business operator that reuses or rebuilds the collected battery 51 depending on the condition of the collected battery.

Here, the vehicle manufacturer bears the amount of $CO_2$ emissions (the amount of $CO_2$ emissions from the battery 51) emitted from the manufacture of the battery 51 when the vehicle 5 is manufactured. When the recycling business operator recycles the battery 51, the recycling business operator can operate the business using the recycled battery 51 without any burden of the amount of $CO_2$ emissions from the battery 51, which has been borne by the vehicle manufacturer. Therefore, there is an unfairness in terms of the burden of the amount of $CO_2$ emissions between the vehicle manufacturer and the recycling business operator.

Accordingly, with the management system 1 according to Embodiment 1, the recycling business operator bears a part of the amount of $CO_2$ emissions of the battery 51, which has been borne by the vehicle manufacturer, according to the degree of deterioration of the battery 51 at a point of time when the battery 51 is recycled. That is, in the management system 1, the amount of $CO_2$ emissions of the battery 51 is apportioned between the vehicle manufacturer and the recycling business operator according to the degree of deterioration of the battery 51 at the point of time when the battery 51 is recycled. The degree of deterioration is, for example, a State of -Health (SOH). SOH is a capacity maintenance rate, and is represented by the ratio [unit: %] of the current full charge capacity C of the battery 51 to a full charge capacity C0 of the battery 51 in an initial state. SOH can be calculated, for example, by the following Equation (1).

$$SOH = C/C0 \times 100 \ldots (1)$$

As the initial value C0 of the full charge capacity, the full charge capacity measured at the time of the manufacture of the battery 51 (or the vehicle 5) may be used, or the specification value (catalog value) of the full charge capacity of the battery 51 may be used. Although the details will be described later, in Embodiment 1, the SOH is calculated by the management device 2 of the vehicle manufacturer.

The management device 3 of the recycling business operator manages the amount of $CO_2$ emissions of the battery 51 to be recycled. The amount of $CO_2$ emissions of the battery 51 to be recycled includes the amount of $CO_2$ emissions apportioned according to the SOH of the battery 51 at the point of time of recycling and the amount of $CO_2$ emissions emitted in a recycling process.

The management device 3 includes a control device 31, a storage device 32, a communication device 33, an input device 34, and a display device 35. The control device 31, the storage device 32, the communication device 33, the input device 34, and the display device 35 are connected to a bus 36. A database 37 is communicably connected to the management device 3. Note that the management device 3 is an example of a "second device".

The control device 31 is built with, for example, an integrated circuit including a CPU. The control device 31 executes various programs stored in the storage device 32. Various programs include an operating system and the like. The storage device 32 includes, for example, a ROM that stores the various programs, and a RAM that functions as a working memory and temporarily stores various data needed to execute the various programs.

The communication device 33 is configured to communicate with the management device 2. Communication between the communication device 33 and the management device 2 (communication device 23) is performed, for example, through the Internet.

The input device 34 includes a device for inputting. The device for inputting is, for example, a mouse, a keyboard, a touch panel, and/or another device capable of accepting user operations.

The display device 35 includes a display. The display device 35 displays various images on the display according to a control signal from the control device 31. The display is, for example, a liquid crystal display, an organic EL display, or another display device.

The database 37 stores information according to a control signal from the management device 3 (control device 31). The control device 31 stores the amount of $CO_2$ emissions (burden share) of the battery 51 to be recycled in the database 37. The amount of $CO_2$ emis-

sions of the battery 51 stored in the database 37 is the amount of $CO_2$ emissions of the battery 51 to be borne by the recycling business operator. The database 37 can also be provided as a storage device within the management device 3.

When the recycling business operator recycles the battery 51, a manager of the management device 3 (for example, an employee of the recycling business operator) first takes out (collects) the battery 51 from the vehicle 5. A battery ID is attached to the battery 51. The manager of the management device 3 operates the input device 34 to display a screen for applying for battery recycling on the display device 35. The manager of the management device 3 operates the input device 34 to enter the battery ID of the battery 51 in a battery ID entry field displayed on the display device 35 and clicks an application button displayed on the display device 35. In this way, the recycling notification of the battery 51 is transmitted to the management device 2 of the vehicle manufacturer that has supplied the vehicle 5 on which the battery 51 specified by the battery ID is mounted to the market. The recycling notification includes the battery ID for specifying the battery 51 to be recycled.

The management device 2 that receives the recycling notification from the management device 3 specifies the battery 51 based on the battery ID, and reads the battery information for the battery 51 from the database 27. Then, the management device 2 calculates the SOH of the battery 51 by using the battery information, and decides an apportion ratio of the amount of $CO_2$ emissions of the battery 51 corresponding to the calculated SOH. According to the apportion ratio, the management device 2 updates the amount of $CO_2$ emissions emitted by manufacturing the battery 51 (the amount of $CO_2$ emissions of the battery 51), and notifies the management device 3 of the amount of $CO_2$ emissions of the battery 51, which is the burden share of the recycling business operator.

The management device 3 stores the amount of $CO_2$ emissions of the battery 51 received from the management device 2 in the database 37 as the amount of $CO_2$ emissions of the battery 51 to be recycled, and manages the stored amount. The amount of $CO_2$ emissions of the battery 51 may be, for example, reported to a purchaser who has purchased the battery from the recycling business operator as the amount of $CO_2$ emissions of a reuse product.

Functional Block

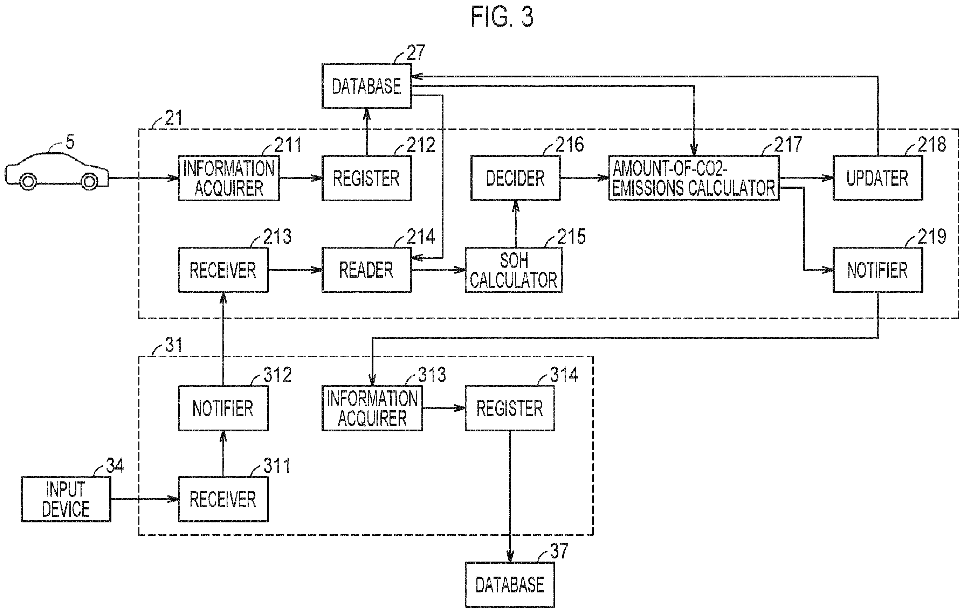

FIG. 3 is a functional block diagram of the control device 21 of the management device 2 and the control device 31 of the management device 3. Referring to FIG. 3, the control device 21 of the management device 2 includes an information acquirer 211, a register 212, a receiver 213, a reader 214, a SOH calculator 215, a decider 216, an amount-of-$CO_2$-emissions calculator 217, an updater 218, and a notifier 219. For example, by executing a program stored in the storage device 22, the control device 21 functions as the information acquirer 211, the register 212, the receiver 213, the reader 214, the SOH calculator 215, the decider 216, the amount-of-CO2-emissions calculator 217, the updater 218, and the notifier 219. The information acquirer 211, the register 212, the receiver 213, the reader 214, the SOH calculator 215, the decider 216, the amount-of-CO2-emissions calculator 217, the updater 218, and the notifier 219 may be implemented by, for example, dedicated hardware (electronic circuit).

The information acquirer 211 acquires battery information (the battery voltage, battery current, battery temperature) from the vehicle 5 through the communication device 23. The information acquirer 211 acquires the battery information from the vehicle 5 at predetermined control cycles at the time when the vehicle 5 is started. The information acquirer 211 outputs the acquired battery information to the register 212.

The register 212 stores, in the database 27, the battery information acquired by the information acquirer 211. The register 212 stores the battery information in the database 27 in association with the battery ID of the battery 51 mounted on the vehicle 5.

The receiver 213 receives a recycling notification from the management device 3 of the recycling business operator. Upon receiving the recycling notification, the receiver 213 outputs the recycling notification to the reader 214.

The reader 214 specifies the battery ID from the recycling notification. The reader 214 reads the battery information associated with the battery ID from the database 27. The reader 214 does not read all the battery information associated with the battery ID; in contrast, the reader 214 reads the most recently stored battery information for a predetermined period (for example, several weeks or several months). The reader 214 outputs the read battery information to the SOH calculator 215.

The SOH calculator 215 extracts battery information that satisfies conditions from the battery information received from the reader 214. The conditions are, for example, that the battery temperature is within a reference temperature range for a predetermined period of time (several minutes to several tens of minutes) and that the battery is continuously discharged. When there is no battery information that satisfies the conditions in the battery information received from the reader 214, the SOH calculator 215 may relax the conditions. For example, the SOH calculator 215 may reduce the predetermined period of time (several minutes to several tens of minutes). The reader 214 may read battery information that satisfies the conditions from the database 27 and output the battery information to the SOH calculator 215.

The SOH calculator 215 calculates the SOC of the battery 51 using the temporally earliest battery information in the battery information that satisfies the conditions. The SOC is referred to as a "first SOC" and is also referred to as SOC1. As a method of estimating the SOC, for example, a method of obtaining the SOC from an open circuit voltage (OCV) by referring to the OCV-SOC curve of the battery 51 acquired in advance can be used. The OCV-SOC curve can be stored in advance in the storage device 22, for example. Next, the SOH calculator 215 calculates the SOC of the battery 51 using the temporally latest battery information in the battery information that satisfies the conditions. The SOC is referred to as a "second SOC" and is also referred to as SOC2.

The SOH calculator 215 calculates a charge and discharge electric power amount ΔAh that has charged the battery 51 and been discharged from the battery 51, during an interval from the first SOC up to the second SOC. The charge and discharge electric power amount ΔAh can be calculated by integrating the current values included in the battery information during the interval from the first SOC up to the second SOC. The unit of the charge and discharge electric power amount ΔAh is not limited to ampere-hours, and may be watt-hours.

The SOH calculator 215 calculates the full charge capacity C of the battery 51 according to the following Equation (2) by using the first SOC, the second SOC, and the charge and discharge electric power amount ΔAh.

$$C = \Delta Ah/|SOC1 - SOC2| \times 100 \; ... \; (2)$$

Then, the SOH calculator 215 calculates the SOH of the battery 51 by dividing the full charge capacity C by the initial value C0 of the full charge capacity of the battery 51 according to Equation (1). The SOH calculator 215 outputs the calculated SOH to the decider 216.

The decider 216 decides an apportion ratio (burden ratio) for the amount of CO2 emissions of the battery 51 according to the SOH. For example, the decider 216 decides that the apportion ratio for the amount of CO2 emissions of the battery 51 between the vehicle manufacturer and the recycling business operator is 60:40 when the SOH is 40%. Taking the battery 51 with the battery ID "B001" as an example, when the SOH is 40%, the decider 216 decides that the vehicle manufacturer continues to bear 60% of the amount of CO2 emissions "M1" of the battery 51, which has been borne by the vehicle manufacturer at the time of supplying the vehicle 5 to the market (for example, at the time of shipment), and that 40% of the amount of CO2 emissions "M1" of the battery 51 are borne by the recycling business operator. The decider 216 outputs the decided apportion ratio to the amount-of-CO2-emissions calculator 217.

The amount-of-CO2-emissions calculator 217 calculates the amount of CO2 emissions of the battery 51 to be borne by the vehicle manufacturer (M1 × 0.6 in the example) and the amount of CO2 emissions of the battery 51 to be borne by the recycling business operator (M1 × 0.4 in the above example), according to the apportion ratio decided by the decider 216. Then, the amount-of-CO2-emissions calculator 217 outputs, to the notifier 219, each of the amount of CO2 emissions of the battery 51 to be borne by the vehicle manufacturer to the updater 218 and the amount of CO2 emissions of the battery 51 to be borne by the recycling business operator.

The updater 218 updates the information about the amount of CO2 emissions of the vehicle (FIG. 2) stored in the database 27. In the above example, the updater 218 updates the amount of CO2 emissions "M1" of the battery ID "B001" to "M1 $\times$ 0.6". Along with the update, the updater 218 also updates the amount of CO2 emissions "SI" of the vehicle.

The notifier 219 notifies, through the communication device 23, the management device 3 of the recycling business operator of the amount of CO2 emissions of the battery 51 to be borne by the recycling business operator.

The control device 31 of the management device 3 includes a receiver 311, a notifier 312, an information acquirer 313, and a register 314. The control device 31 functions as the receiver 311, the notifier 312, the information acquirer 313, and the register 314 by executing programs stored in the storage device 32, for example. The receiver 311, the notifier 312, the information acquirer 313, and the register 314 may be implemented by dedicated hardware (electronic circuits), for example.

The receiver 311 receives an application for recycling from the input device 34. The application for recycling includes the battery ID. Upon receiving the application for recycling, the receiver 311 outputs the application for recycling to notifier 312 together with the battery ID.

The notifier 312 generates a recycling notification and transmits the generated recycling notification to the management device 2 of the vehicle manufacturer through the communication device 33. The recycling notification is acquired by the receiver 213 of the control device 21. In this way, the notification of the amount of CO2 emissions of the battery 51 to be borne by the recycling business operator is issued from the management device 2.

The information acquirer 313 acquires the amount of CO2 emissions of the battery 51 to be borne by the recycling business operator from the management device 2 of the vehicle manufacturer through the communication device 33. The information acquirer 313 outputs the acquired amount of CO2 emissions of the battery 51 to the register 314.

The register 314 stores the amount of CO2 emissions of the battery 51 in the database 37 in association with the battery ID of the battery 51.

When there is an amount of CO2 emissions emitted due to recycling of the battery 51, the amount of CO2 emissions is added to the amount of CO2 emissions of the battery 51 stored in the database 37 (M1 $\times$ 0.4 in the example), and the information in the database 37 is updated. The timing at which the amount of CO2 emissions emitted due to recycling of the battery 51 is added is optional.

Flowchart

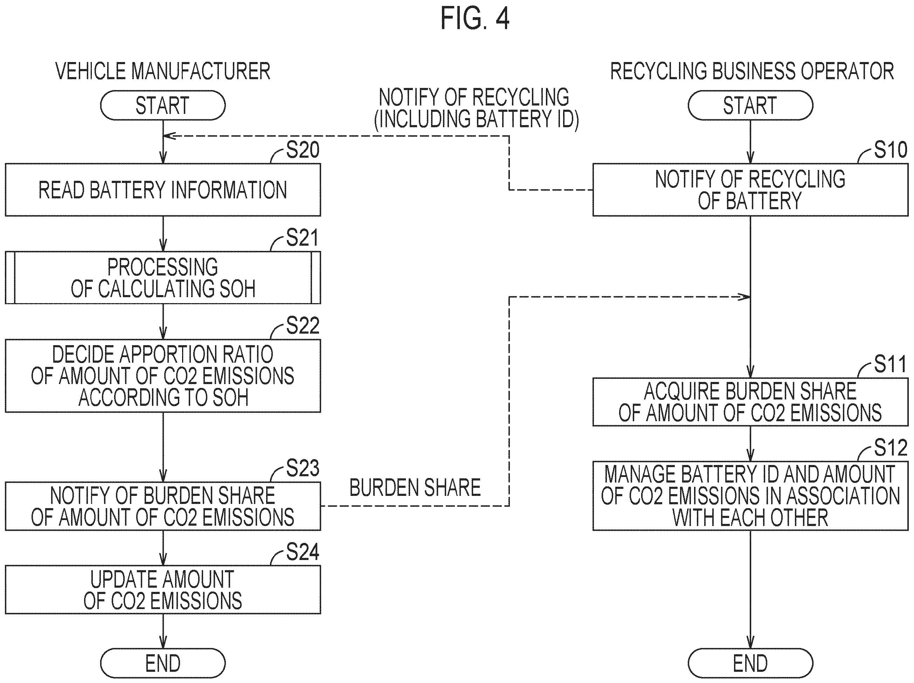

FIG. 4 is a flowchart showing a procedure of a process executed at the time when the battery is recycled. The flowchart is executed by the control device 21 of the management device 2 and the control device 31 of the management device 3 when the battery is recycled. Each step (hereinafter abbreviated as "S") of the flowchart shown in FIG. 4 is described as being carried out by software processing by the control device 21 of the management device 2 and the control device 31 of the management device 3; however, some or all of the steps may be carried out by hardware (electrical circuits) fabricated in the control devices 21, 31.

In S10, upon receiving an application for recycling of the battery 51 from the input device 34, the control device 31 generates a recycling notification regarding the battery 51 and transmits the generated recycling notification to the management device 2.

In S20, when the control device 21 receives the recycling notification, the control device 21 reads battery information associated with the battery ID (for example, battery ID "B001") from the database 27 based on the battery ID (for example, battery ID "B001") included in the recycling notification. As described above, the battery information read in S20 is the most recently stored battery information for a predetermined period.

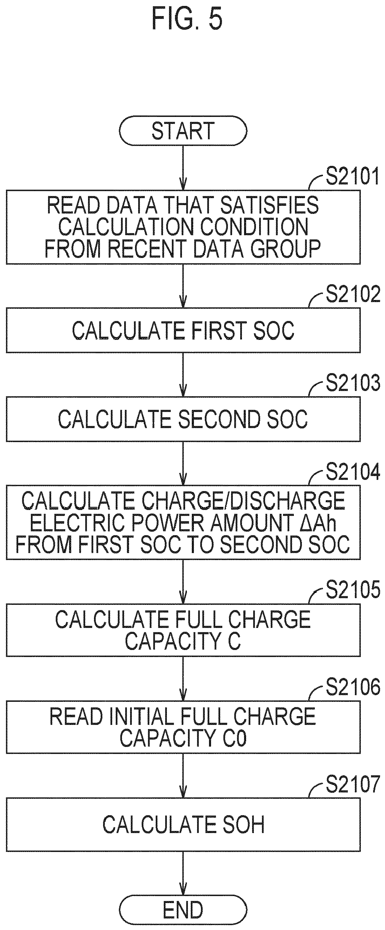

In S21, the control device 21 calculates the SOH of the battery 51. FIG. 5 is a flowchart showing a detailed process for an operation of S21.

In S2101, the control device 21 extracts battery information that satisfies a condition in the read battery information.

In S2102, the control device 21 calculates the first SOC by using the temporally earliest battery information in the battery information that satisfies the condition.

In S2103, the control device 21 calculates the second SOC by using the temporally latest battery information in the battery information that satisfies the condition.

In S2104, the control device 21 calculates the charge and discharge electric power amount $\Delta Ah$ that has charged the battery 51 and/or been discharged from the battery 51 by integrating current values during the interval from the first SOC up to the second SOC.

In S2105, the control device 21 calculates the full charge capacity C of the battery 51 according to Equation (2) by using the first SOC, the second SOC, and the charge and discharge electric power amount $\Delta Ah$.

In S2106, the control device 21 reads the initial full charge capacity C0 of the battery 51 from the database 27. The full charge capacity C0 may be stored in the storage device 22.

In S2107, the control device 21 calculates the SOH of the battery 51 by dividing the full charge capacity C by the initial value C0 of the full charge capacity of the battery 51 according to Equation (1).

Referring back to FIG. 4, in S22, the control device 21 decides the apportion ratio (burden ratio) of the amount of CO2 emissions between the vehicle manufacturer and the recycling business operator according to the SOH.

In S23, the control device 21 calculates the amount of CO2 emissions of the battery 51 to be borne by the vehicle manufacturer and the amount of CO2 emissions of the battery 51 to be borne by the recycling business operator, according to the decided apportion ratio. Then, the control device 21 notifies the management device 3 of the amount of CO2 emissions (burden share) of the battery 51 to be borne by the recycling business operator through the communication device 23.

In S24, the control device 21 updates the amount of CO2 emissions of the battery 51, which is included in the amount of CO2 emissions of the vehicle stored in the database 27, to the amount of CO2 emissions of the battery 51 to be borne by the vehicle manufacturer, and ends the process. In the example (when the battery 51 with the battery ID "B001" with the SOH of 40% is recycled), the control device 21 updates the amount of CO2 emissions "M1" of the battery 51 included in the amount of CO2 emissions "S1" of the vehicle stored in the database 27 to the amount of CO2 emissions "M1 × 0.6" of the battery 51, which is the burden share of the vehicle manufacturer, and ends the process.

In S11, the control device 31 acquires the amount of CO2 emissions of the battery 51, which is the burden share of the recycling business operator, from the management device 2 through the communication device 33.

In S12, the control device 31 stores the amount of CO2 emissions of the battery 51 in the database 37 in association with the battery ID of the battery 51. The stored amount of CO2 emissions of the battery 51 may be, for example, reported to a business operator who has purchased the battery 51 from the recycling business operator as the amount of CO2 emissions of a reuse product.

As described above, in the management system 1 according to the present embodiment, the management device 2 of the vehicle manufacturer apportions the amount of CO2 emissions of the battery 51, which has been borne by the vehicle manufacturer, with the management device 3 of the recycling business operator, according to the SOH of the battery 51 at the point of time when the battery 51 is recycled. Since the amount of CO2 emissions of the battery 51 is apportioned according to the SOH at the point of time of being recycled, the amount of CO2 emissions of the battery 51 can be fairly borne by the management devices 2, 3.

Modification Example 1

In Embodiment 1, it is assumed that the vehicle 5 is a battery electric vehicle, a hybrid electric vehicle, a plug-in hybrid electric vehicle, a fuel cell electric vehicle, or the like. In Modification Example 1, it is assumed that the vehicle 5 is a vehicle capable of external charging in which the battery 51 is charged using electric power supplied from an external power supply. That is, examples of the vehicle 5 include a battery electric vehicle, a plug-in hybrid electric vehicle, and a plug-in fuel cell electric vehicle. The external charging may be alternating current (AC) charging in which the battery 51 is charged by receiving AC power supplied from an external AC power supply, or may be direct current (DC) charging in which the battery 51 is charged by receiving DC power supplied from an external DC power supply.

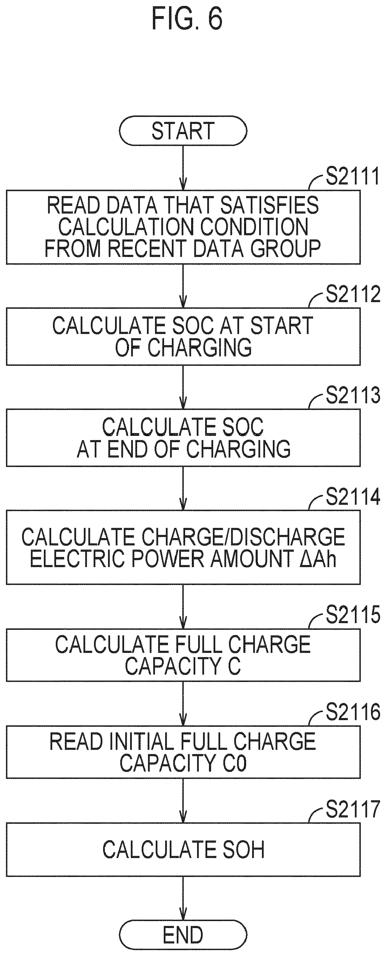

In Modification Example 1, a condition that the battery information is acquired during external charging can be employed as the condition for battery information used to calculate the SOH. In Modification Example 1, a process shown in FIG. 6 can be employed as the details of the process for S21 (SOH calculation process) shown in FIG. 4.

FIG. 6 is a flowchart showing a detailed process for the operation of S21 in FIG. 4, according to Modification Example 1.

In S2111, the control device 21 extracts battery information that satisfies a condition in the read battery information. The condition is that the battery information is acquired during external charging. A determination as to whether or not the battery information is acquired during external charging can be made based on, for example, a charging start flag and a charging end flag included in the battery information.

In S2112, the control device 21 calculates the SOC at the start of external charging (start SOC) by using the battery information at the start of external charging.

In S2113, the control device 21 calculates the SOC (end SOC) at the end of the external charging by using the battery information at the end of the external charging.

In S2114, the control device 21 calculates the charge and discharge electric power amount $\Delta Ah$ that has charged the battery 51 and been discharged from the battery 51 by integrating the current values during an interval from the start to the end of external charging (that is, from the start SOC to the end SOC).

In S2115, the control device 21 calculates the full charge capacity C of the battery 51 according to Equation (2) by using the start SOC, the end SOC, and the charge and discharge electric power amount $\Delta Ah$.

In S2116, the control device 21 reads the initial full charge capacity C0 of the battery 51 from the database 27. The full charge capacity C0 may be stored in the storage device 22.

In S2117, the control device 21 calculates the SOH of the battery 51 by dividing the full charge capacity C by the initial value C0 of the full charge capacity of the battery 51 according to Equation (1).

As described above, in Modification Example 1, the SOH of the battery 51 is calculated by using the battery information acquired during external charging. It can be said that the battery information acquired during external charging is data acquired in a more stable environment than the battery information acquired while the vehicle 5 is traveling. Therefore, by calculating the SOH of the battery 51 by using the battery information acquired during external charging, the accuracy of the SOH calculation can be improved.

Modification Example 2

In Embodiment 1 and Modification Example 1, the examples in which the management device 2 of the vehicle manufacturer calculates the SOH of the battery 51 have been described. However, the vehicle 5 may calculate the SOH, and the management device 2 may acquire information indicating the SOH from the vehicle 5.

For example, the vehicle 5 calculates the SOH of the battery 51 when a predetermined calculation condition is established. As the calculation condition, a condition that external charging is executed, a condition that discharging is performed over a certain period while the vehicle is traveling, or the like can be employed. After calculating the SOH, the vehicle 5 transmits the calculated SOH to the management device 2 together with the battery ID.

When the control device 21 of the management device 2 receives the SOH and the battery ID through the communication device 23, the control device 21 stores the received SOH in the database 27 in association with the battery ID. The control device 21 stores the received SOH in the database 27 in association with the battery ID every time the control device 21 receives the SOH from the vehicle 5.

When the battery 51 is recycled (when a recycling notification is received), the control device 21 reads out the most recently received SOH from the database 27. Then, the control device 21 decides the apportion ratio of the amount of $CO_2$ emissions of the battery 51 between itself (vehicle manufacturer) and the recycling business operator, according to the read SOH.

With the configuration as described above, the same effects as those of Embodiment 1 and Modification Example 1 can be obtained.

Embodiment 2

In Embodiment 1 and Modification Example 1, the examples in which the management device 2 of the vehicle manufacturer calculates the SOH of the battery 51 have been described. In Modification Example 2, the example in which the vehicle 5 calculates the SOH of the battery 51 and the SOH is transmitted to the management device 2 of the vehicle manufacturer has been described. In Embodiment 2, an example in which the management device 3 of the recycling business operator calculates the SOH of the battery 51 will be described.

Referring back to FIG. 1, a management system 1A according to Embodiment 2 includes a control device 21A and a control device 31A, which are substituted for the control device 21 of the management device 2 and the control device 31 of the management device 3 in the management system 1 according to Embodiment 1, respectively. Other configurations of the management system 1A are basically the same as those of the management system 1.

In the management system 1A, the management device 3 of the recycling business operator calculates the SOH of the battery 51, and decides the apportion ratio of the amount of $CO_2$ emissions emitted by manufacturing the battery 51 according to the calculated SOH. Then, the management device 3 of the recycling business operator notifies the management device 2 of the vehicle manufacturer of the amount of $CO_2$ emissions (burden share) of the battery 51 to be borne by the vehicle manufacturer.

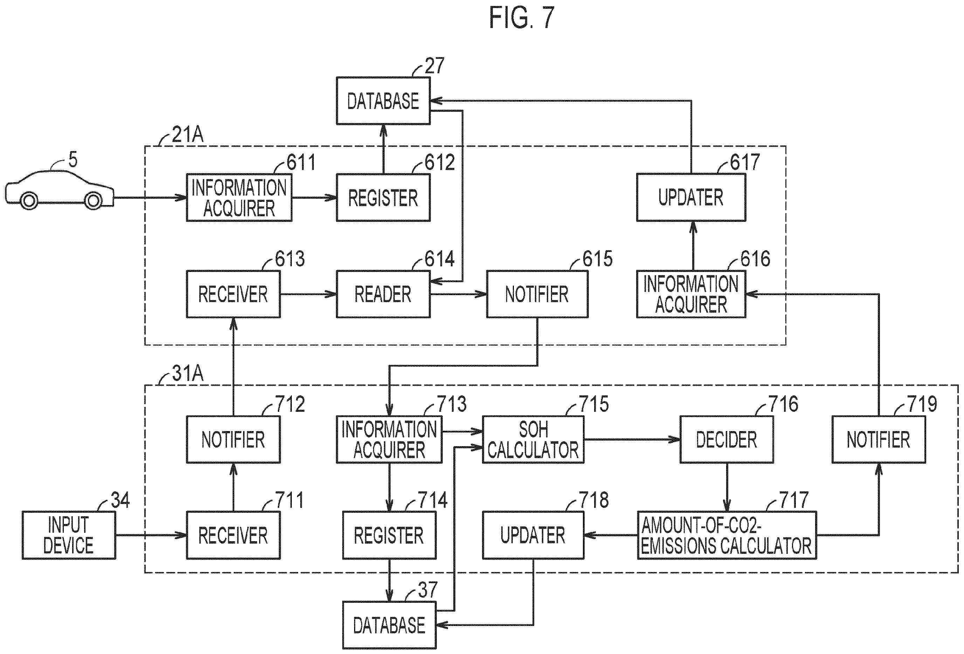

FIG. 7 is a functional block diagram of the control device 21A of the management device 2 and the control device 31A of the management device 3 according to Embodiment 2. Referring to FIG. 7, the control device 21A of management device 2 includes an information acquirer 611, a register 612, a receiver 613, a reader 614, a notifier 615, an information acquirer 616, and an updater 617. For example, by executing a program stored in the storage device 22, the control device 21A functions as the information acquirer 611, the register 612, the receiver 613, the reader 614, the notifier 615, the information acquirer 616, and the updater 617. The information acquirer 611, the register 612, the receiver 613, the reader 614, the notifier 615, the information acquirer 616, and the updater 617 may be implemented by, for example, dedicated hardware (electronic circuit).

The information acquirer 611 and the register 612 have the same functions as the information acquirer 211 and the register 212 according to Embodiment 1, respectively, and thus description thereof will not be repeated.

The receiver 613 receives a recycling notification from the management device 3 of the recycling business operator. Upon receiving the recycling notification, the receiver 613 outputs the recycling notification to the reader 614.

The reader 614 specifies the battery ID from the recycling notification. The reader 614 reads the amount of $CO_2$ emissions (the amount of $CO_2$ emissions of the battery 51) emitted by manufacturing the battery 51 from the database 27 based on the battery ID. In the example shown in FIG. 2, when the battery ID of the battery 51 is "B001", the reader 614 reads the amount of $CO_2$ emissions "M1" of the battery 51. The reader 614 outputs the read amount of $CO_2$ emissions "M1" of the battery 51 to the notifier 615.

The notifier 615 notifies the management device 3 of the recycling business operator of the amount of $CO_2$ emissions "M1" of the battery 51 through the communication device 23.

The information acquirer 616 acquires the amount of CO2 emissions of the battery 51 to be continuously borne by the vehicle manufacturer from the management device 3 of the recycling business operator. The information acquirer 616 outputs the received burden share of the amount of CO2 emissions to the updater 617.

The updater 617 updates information about the amount of CO2 emissions of the vehicle (FIG. 2) stored in the database 27 based on the burden share of the amount of CO2 emissions received from the information acquirer 616. Here, as an example, it is assumed that information indicating that the burden share is 60% for battery ID "B001" is received from the information acquirer 616. In this case, the updater 617 updates the amount of CO2 emissions "M1" of the battery ID "B001" to "M1 $\times$ 0.6". Along with the update, the updater 617 also updates the amount of CO2 emissions "S1" of the vehicle.

The control device 31A of the management device 3 includes a receiver 711, a notifier 712, an information acquirer 713, a register 714, an SOH calculator 715, a decider 716, an amount-of-CO2-emissions calculator 717, an updater 718, and a notifier 719. For example, by executing a program stored in the storage device 32, the control device 31A functions as the receiver 711, the notifier 712, the information acquirer 713, the register 714, the SOH calculator 715, the decider 716, the amount-of-CO2-emissions calculator 717, the updater 718, and the notifier 719. The receiver 711, the notifier 712, the information acquirer 713, the register 714, the SOH calculator 715, the decider 716, the amount-of-CO2-emissions calculator 717, the updater 718, and the notifier 719 may be implemented by, for example, dedicated hardware (electronic circuit).

The receiver 711 and notifier 712 have the same functions as the receiver 311 and the notifier 312 according to Embodiment 1, respectively, and thus description thereof will not be repeated.

The information acquirer 713 acquires the amount of CO2 emissions of the battery 51 from the management device 2 of the vehicle manufacturer through the communication device 33. The information acquirer 713 outputs the acquired amount of CO2 emissions of the battery 51 to the register 714 and the SOH calculator 715. Here, it is assumed that the battery 51 specified by the battery ID "B001" is recycled. That is, the information acquirer 713 outputs the amount of CO2 emissions "M1" of the battery 51 to the register 714 and the SOH calculator 715.

The register 714 stores the amount of CO2 emissions of the battery 51 acquired by the information acquirer 713 in the database 37 in association with the battery ID of the battery 51. Specifically, information about the amount of CO2 emissions "M1" of the battery 51 is stored in the database 37 in association with the battery ID "B001". The information is stored in the database 37 as temporary information before the apportionment of the amount of CO2 emissions.

The SOH calculator 715 calculates the SOH of the battery 51. The recycling business operator implements an inspection process for checking the SOH of the battery 51 collected from the vehicle 5. In the inspection process, for example, the battery 51 is charged until the battery 51 is fully charged, and then the battery 51 is discharged until the battery 51 reaches a specified SOC. Then, an integrated value of current values discharged from the battery 51 during an interval from full charge up to the specified SOC is acquired. In the inspection process, inspection information including information such as the voltage of the battery 51 at the time of being fully charged, the voltage of the battery 51 at the specified SOC, and the integrated value of the current value is acquired. The inspection information is stored in the database 37. The SOH calculator 715 reads the inspection information from the database 37. The SOH calculator 715 calculates the SOH of the battery 51 based on the inspection information. The SOH calculator 715 outputs the calculated SOH and the amount of CO2 emissions "M1" of the battery 51 received from the information acquirer 713 to the decider 716. The inspection process may be executed by using, for example, a dedicated or general-purpose charging/discharging device.

Note that the timing of executing the inspection process is optional. For example, the inspection process may be executed before the recycling notification is transmitted from the management device 3 to the management device 2, or may be executed after the transmission. When the inspection information has not yet been registered in the database 37, the SOH calculator 715 waits for the registration of the inspection information, for example.

The decider 716 decides the apportion ratio (burden ratio) of the amount of CO2 emissions of the battery 51 according to the SOH by the same method as the decider 216 according to Embodiment 1. Here, it is assumed that the SOH is 40% and the apportion ratio of the amount of CO2 emissions of the battery 51 between the vehicle manufacturer and the recycling business operator is decided to be 60:40. The decider 716 outputs the decided apportion ratio to the amount-of-CO2-emissions calculator 717. Further, the decider 716 outputs the amount of CO2 emissions "M1" of the battery 51 to the amount-of-CO2-emissions calculator 717.

The amount-of-CO2-emissions calculator 717 calculates the amount of CO2 emissions of the battery 51 to be borne by the vehicle manufacturer (M1 $\times$ 0.6 in the example) and the amount of CO2 emissions of the battery 51 to be borne by the recycling business operator (M1 $\times$ 0.4 in the example), according to the apportion ratio decided by the decider 716. Then, the amount-of-CO2-emissions calculator 717 outputs, to the updater 718, the amount of CO2 emissions of the battery 51 to be borne by the recycling business operator "M1 $\times$ 0.4" and outputs, to the notifier 719, the amount of CO2 emissions of the battery 51 to be borne by the vehicle manufacturer "M1 $\times$ 0.6".

The updater 718 updates the amount of CO2 emissions of the battery 51 stored in the database 37 (information registered by the register 714). In the example, the updater 718 updates the amount of $CO_2$ emissions "M1" of the battery ID "B001" to "M1 × 0.4". When there is the amount of $CO_2$ emissions emitted due to recycling of the battery 51, the updater 718 adds the amount of $CO_2$ emissions to the amount of $CO_2$ emissions of the battery 51 stored in the database 37 (in the above example, M1 × 0.4).

The notifier 719 notifies the management device 2 of the vehicle manufacturer of the amount of $CO_2$ emissions "M1 × 0.6" of the battery 51 to be borne by the vehicle manufacturer together with the battery ID "001", through the communication device 33.

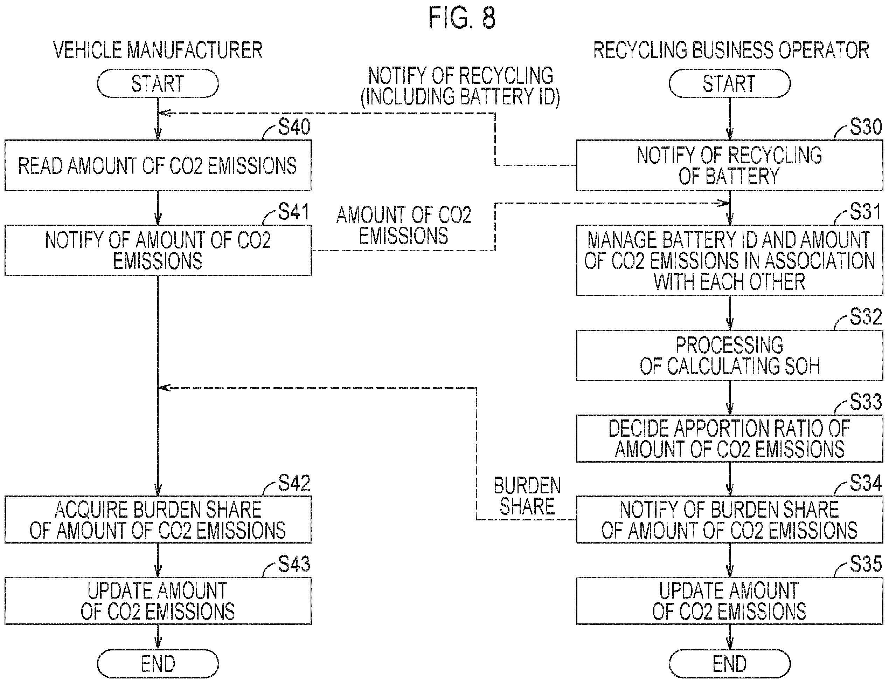

FIG. 8 is a flowchart showing a procedure of a process executed at the time when a battery is recycled, according to Embodiment 2. The flowchart is executed by the control device 21A of the management device 2 and the control device 31A of the management device 3 when the battery is recycled.

In S30, upon receiving an application for recycling of the battery 51 from the input device 34, the control device 31A generates a recycling notification regarding the battery 51 and transmits the generated recycling notification to the management device 2 through the communication device 33. Here, it is assumed that the battery 51 specified by the battery ID "B001" is recycled.

In S40, when the control device 21A receives the recycling notification through the communication device 23, the control device 21A reads the amount of $CO_2$ emissions (amount of $CO_2$ emissions of the battery 51) "M1" emitted by manufacturing the battery 51 from the database 27, based on the battery ID "B001" included in the recycling notification.

In S41, the control device 21A transmits the amount of $CO_2$ emissions "M1" of the battery 51 that has been read in S40 to the management device 3 through the communication device 23.

In S31, the control device 31A acquires the amount of $CO_2$ emissions "M1" of the battery 51 from the management device 2 through the communication device 33. The control device 31A stores the amount of $CO_2$ emissions "M1" of the battery 51 in the database 37 in association with the battery ID "B001".

In S32, the control device 31A reads inspection information from the database 37. Then, the control device 31A calculates the SOH of the battery 51 based on the inspection information. Here, it is assumed that the SOH of the battery 51 is 40%. As described above, the inspection information is acquired by the inspection process for the battery 51. The inspection process may be executed in advance or may be executed at the timing of S32. The inspection information acquired by the inspection process is stored in the database 37.

In S33, the control device 31A decides the apportion ratio (burden ratio) of the amount of $CO_2$ emissions between the vehicle manufacturer and the recycling business operator according to the SOH.

In S34, the control device 31A calculates the amount of $CO_2$ emissions "M1 × 0.6" of the battery 51 to be borne by the vehicle manufacturer and the amount of $CO_2$ emissions "M1 × 0.4" of the battery 51 to be borne by the recycling business operator, according to the decided apportion ratio. Then, the control device 31A notifies the management device 2 of the amount of $CO_2$ emissions (burden share) of the battery 51 to be borne by the vehicle manufacturer through the communication device 33.

In S35, the control device 31A updates the amount of $CO_2$ emissions "M1" of the battery 51 stored in the database 37 in S31 to the amount of $CO_2$ emissions "M1 × 0.4" of the battery 51 to be borne by the recycling business operator, which is calculated in S34, and ends the process.

In S42, the control device 21A acquires the amount of $CO_2$ emissions "M1 × 0.6" of the battery 51, which is the burden share of the vehicle manufacturer, from the management device 3 through the communication device 23.

In S43, the control device 21A updates the amount of $CO_2$ emissions "M1" of the battery 51, which is included in the amount of $CO_2$ emissions of the vehicle stored in the database 27, to the amount of $CO_2$ emissions "M1 × 0.6" of the battery 51 to be borne by the vehicle manufacturer, and ends the process.

As described above, in the management system 1A according to Embodiment 2, the management device 3 of the recycling business operator decides the apportion ratio of the amount of $CO_2$ emissions between the vehicle manufacturer and the recycling business operator according to the SOH of the battery 51 at the point of time when the battery 51 is recycled. Then, based on the apportion ratio, the management device 3 bears a portion of the amount of $CO_2$ emissions of the battery 51 that has been borne by the vehicle manufacturer. Since the amount of $CO_2$ emissions of the battery 51 is apportioned between the vehicle manufacturer and the recycling business operator according to the SOH at the point of time of being recycled, the amount of $CO_2$ emissions of the battery 51 can be fairly borne by the vehicle manufacturer and the recycling business operator.

Modification Example 3

In Embodiment 2, the management device 3 of the recycling business operator has calculated the SOH of the battery 51 and decided the apportion ratio of the amount of $CO_2$ emissions of the battery 51 according to the SOH. However, the management device 3 of the recycling business operator may transmit the calculated SOH of the battery 51 to the management device 2 of the vehicle manufacturer, and the management device 2 of the vehicle manufacturer may decide the apportion ratio of the amount of $CO_2$ emissions of the battery 51 according to the SOH. That is, in the functional block diagram shown in FIG. 7, the control device 21A of the management device 2 may have the functions of the decider 716 and the amount-of-CO2-emissions calculator 717 that the control device 31A of the management device 3 has.

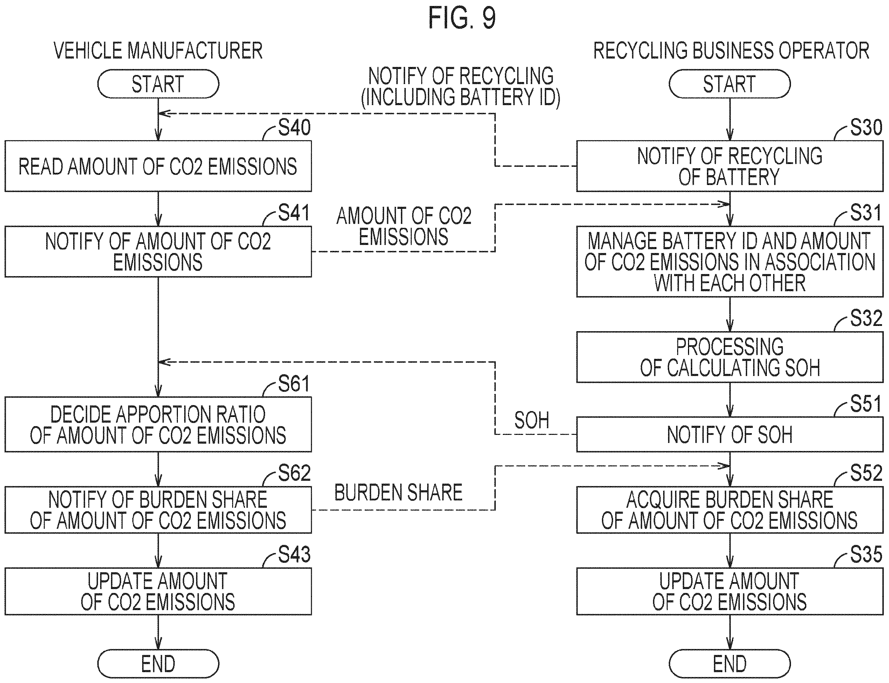

FIG. 9 is a flowchart showing a procedure of a process executed at the time when a battery is recycled, according to Modification Example 3. In the flowchart, with regard to the flowchart of FIG. 8, operations of S33 and S34 are deleted from the operations executed by the control device 31A, operations of S51, S52 are added to the operations executed by the control device 31A, and operations of S61, S62 are added to the operations executed by the control device 21A. Other operations in the flowchart of FIG. 9 is the same as the operations in the flowchart of FIG. 8, and thus the same numbers are given to the same steps and the description thereof will not be repeated.

In S51, the control device 31A transmits the SOH of the battery 51 calculated in S32 to the management device 2 through the communication device 33.

In S61, the control device 21A decides the apportion ratio of the amount of CO2 emissions between the vehicle manufacturer and the recycling business operator according to the SOH.

In S62, the control device 21A calculates the amount of CO2 emissions of the battery 51 to be borne by the vehicle manufacturer and the amount of CO2 emissions of the battery 51 to be borne by the recycling business operator, according to the decided apportion ratio. Then, the control device 21A notifies the management device 3 of the amount of CO2 emissions (burden share) of the battery 51 to be borne by the recycling business operator through the communication device 23.

In S52, the control device 31A acquires the amount of CO2 emissions of the battery 51, which is the burden share of the recycling business operator, from the management device 2 through the communication device 33.

As described above, even in the configuration of Modification Example 3, the same effect as in Embodiment 2 can be obtained.

Modification Example 4

In Embodiment 1, the examples in which the management device 2 of the vehicle manufacturer calculates the SOH of the battery 51 have been described. In Modification Example 2, the example in which the vehicle 5 calculates the SOH of the battery 51 and the SOH is transmitted to the management device 2 of the vehicle manufacturer has been described. Further, in Embodiment 2 and Modification Example 3, the examples in which the management device 3 of the recycling business operator calculates the SOH of the battery 51 have been described. The SOH of the battery 51 may be calculated by a neutral third party different from the vehicle manufacturer and the recycling business operator. Both the vehicle manufacturer and the recycling business operator may request that the vehicle manufacturer and the recycling business operator themselves calculate the SOH of the battery 51 related to the amount of CO2 emissions to be borne. Therefore, a service provider (third party) that provides a service for calculating the SOH of the battery 51 and the like may be entrusted with the calculation of the SOH of the battery 51.

For example, the management device 2 of the vehicle manufacturer may transmit the battery information to the service provider and acquire the SOH of the battery 51 from the service provider as a reply. Further, the management device 3 of the recycling business operator may transmit the inspection information to the service provider and acquire the SOH of the battery 51 from the service provider as a reply.

By having the service provider, which is a third party, calculate the SOH of the battery 51, it is possible to apportion the amount of CO2 emissions of the battery 51 more appropriately between the vehicle manufacturer and the recycling business operator.

Modification Example 5

In Embodiment 1 and Embodiment 2, and Modification Example 1 to Modification Example 4, the examples in which the recycling business operator reuses the battery have been described. When the recycling business operator rebuilds the battery, the battery can be read as a "cell" in the methods described in Embodiment 1 and Embodiment 2, and Modification Example 1 to Modification Example 4. A cell ID for specifying a cell is attached to each of the plurality of cells included in the battery. Therefore, in the case where the amount of CO2 emissions is apportioned in units of cells in the same manner as in Embodiment 1 and Embodiment 2, and Modification Example 1 to Modification Example 4, when the battery is rebuilt, the amount of CO2 emissions emitted by manufacturing the battery can be appropriately apportioned between the vehicle manufacturer and the recycling business operator.

Further, when the recycling business operator performs both reusing and rebuilding, the management device 3 of the recycling business operator determines whether to reuse or rebuild the battery 51 based on the SOH of the battery 51 collected from the vehicle 5, for example. For example, the management device 3 may reuse the battery 51 when the SOH of the battery 51 is greater than the reference value, and may rebuild the battery 51 when the SOH of the battery 51 is equal to or lower than the reference value. The reference value can be appropriately set based on, for example, the specifications of the battery 51, the business content of the recycling business operator, or a use application of the reseller.

Modification Example 6

In Embodiment 1 and Embodiment 2, and Modification Example 1 to Modification Example 5, the case where the battery mounted on the automobile is recycled has been described as an example. However, the object on which the recycled battery is mounted is not limited to the automobile. The object on which the recycled battery is mounted may be any moving body on which the battery is mounted, such as a two-wheeled vehicle, a train, a ship, an airplane, or the like.

The embodiments disclosed herein are to be considered to be illustrative and not restrictive in every respect. The scope of the present disclosure is defined not by the detailed description of embodiments but by the claims, and is intended to cover all equivalents and all modifications within the scope of the claims.

## Claims

1. A management device (2) comprising:

   a storage (27) configured to store an amount of $CO_2$ emissions emitted by manufacturing a secondary battery; and
   a controller (21; 21A) configured to, when the secondary battery is recycled by a business operator who recycles the secondary battery, apportion the amount of $CO_2$ emissions with the business operator according to a degree of deterioration of the secondary battery at a time of being recycled.

2. The management device (2) according to claim 1, further comprising a communicator (23), wherein:

   the secondary battery is mounted on a moving body;
   the communicator (23) is configured to communicate with the moving body; and
   the controller (21; 21A) is configured to

   acquire information about the secondary battery from the moving body through the communicator (23), and
   when the secondary battery is recycled, calculate the degree of deterioration by using the information.

3. The management device (2) according to claim 1, further comprising a communicator (23), wherein:

   the secondary battery is mounted on a moving body;
   the communicator (23) is configured to communicate with the moving body; and
   the controller (21; 21A) is configured to, when the secondary battery is recycled, acquire the degree of deterioration from the moving body through the communicator (23).

4. The management device (2) according to claim 1, further comprising a communicator (23) configured to communicate with a management device (3) of the business operator,

   wherein the controller (21; 21A) is configured to, when the secondary battery is recycled, acquire the degree of deterioration from the management device (3) of the business operator through the communicator (23).

5. The management device (2) according to claim 1, further comprising a communicator (23) configured to communicate with a management device (3) of the business operator,

   wherein the controller (21; 21A) is configured to, when the secondary battery is recycled, acquire a burden share of the amount of $CO_2$ emissions corresponding to the degree of deterioration from the management device (3) of the business operator through the communicator (23).

6. The management device (2) according to any one of claims 1 to 5, wherein the degree of deterioration is a capacity maintenance rate of the secondary battery.

7. The management device (2) according to claim 6, wherein the controller (21; 21A) is configured to increase a burden share of the amount of $CO_2$ emissions of the business operator as the capacity maintenance rate when the secondary battery is recycled is higher.

8. A management method comprising:

   storing an amount of $CO_2$ emissions emitted by manufacturing a secondary battery; and
   when the secondary battery is recycled by a business operator who recycles the secondary battery, apportioning the amount of $CO_2$ emissions with the business operator according to a degree of deterioration of the secondary battery at a time of being recycled.

9. A management system (1; 1A) comprising:

   a first device (2) configured to manage an amount of $CO_2$ emissions emitted by manufacturing a secondary battery; and
   a second device (3) of a business operator who recycles the secondary battery, wherein:

      the first device (2) is configured to, when the secondary battery is recycled, update the amount of $CO_2$ emissions according to a degree of deterioration of the secondary battery at a time of being recycled; and
      the second device (3) is configured to manage the amount of CO2 emissions corresponding to the degree of deterioration.

FIG. 1

EP 4 239 553 A1

## FIG. 2

| VEHICLE ID | BATTERY ID | AMOUNT OF CO2 EMISSIONS | ENGINE ID | AMOUNT OF CO2 EMISSIONS | ... | AMOUNT OF CO2 EMISSIONS OF VEHICLE |
|---|---|---|---|---|---|---|
| V001 | B001 | M1 | E001 | N1 | ... | S1 |
| V002 | B002 | M2 | E002 | N2 | ... | S2 |
| ... | ... | ... | ... | ... | ... | ... |

## FIG. 3

EP 4 239 553 A1

# FIG. 4

**VEHICLE MANUFACTURER**

( START )

↓

| READ BATTERY INFORMATION | ⌐S20 |

↓

| PROCESSING OF CALCULATING SOH | ⌐S21 |

↓

| DECIDE APPORTION RATIO OF AMOUNT OF $CO_2$ EMISSIONS ACCORDING TO SOH | ⌐S22 |

↓

| NOTIFY OF BURDEN SHARE OF AMOUNT OF $CO_2$ EMISSIONS | ⌐S23 |

↓

| UPDATE AMOUNT OF $CO_2$ EMISSIONS | ⌐S24 |

↓

( END )

NOTIFY OF RECYCLING
(INCLUDING BATTERY ID)

BURDEN SHARE

**RECYCLING BUSINESS OPERATOR**

( START )

↓

| NOTIFY OF RECYCLING OF BATTERY | ⌐S10 |

↓

| ACQUIRE BURDEN SHARE OF AMOUNT OF $CO_2$ EMISSIONS | ⌐S11 |

↓

| MANAGE BATTERY ID AND AMOUNT OF $CO_2$ EMISSIONS IN ASSOCIATION WITH EACH OTHER | ⌐S12 |

↓

( END )

# FIG. 5

START

↓ S2101

READ DATA THAT SATISFIES
CALCULATION CONDITION
FROM RECENT DATA GROUP

↓ S2102

CALCULATE FIRST SOC

↓ S2103

CALCULATE SECOND SOC

↓ S2104

CALCULATE CHARGE/DISCHARGE
ELECTRIC POWER AMOUNT ΔAh
FROM FIRST SOC TO SECOND SOC

↓ S2105

CALCULATE FULL CHARGE
CAPACITY C

↓ S2106

READ INITIAL FULL CHARGE
CAPACITY C0

↓ S2107

CALCULATE SOH

↓

END

# FIG. 6

```
        ( START )
            │
            ▼                              ⌐S2111
┌─────────────────────────────────┐
│   READ DATA THAT SATISFIES      │
│     CALCULATION CONDITION       │
│   FROM RECENT DATA GROUP        │
└─────────────────────────────────┘
            │
            ▼                              ⌐S2112
┌─────────────────────────────────┐
│    CALCULATE SOC AT START        │
│        OF CHARGING               │
└─────────────────────────────────┘
            │
            ▼                              ⌐S2113
┌─────────────────────────────────┐
│       CALCULATE SOC              │
│     AT END OF CHARGING           │
└─────────────────────────────────┘
            │
            ▼                              ⌐S2114
┌─────────────────────────────────┐
│  CALCULATE CHARGE/DISCHARGE     │
│  ELECTRIC POWER AMOUNT ΔAh      │
└─────────────────────────────────┘
            │
            ▼                              ⌐S2115
┌─────────────────────────────────┐
│    CALCULATE FULL CHARGE         │
│        CAPACITY C                │
└─────────────────────────────────┘
            │
            ▼                              ⌐S2116
┌─────────────────────────────────┐
│   READ INITIAL FULL CHARGE       │
│        CAPACITY C0               │
└─────────────────────────────────┘
            │
            ▼                              ⌐S2117
┌─────────────────────────────────┐
│       CALCULATE SOH              │
└─────────────────────────────────┘
            │
            ▼
         ( END )
```

FIG. 7

# FIG. 8

**VEHICLE MANUFACTURER**

START

READ AMOUNT OF CO2 EMISSIONS — S40

NOTIFY OF AMOUNT OF CO2 EMISSIONS — S41

ACQUIRE BURDEN SHARE OF AMOUNT OF CO2 EMISSIONS — S42

UPDATE AMOUNT OF CO2 EMISSIONS — S43

END

**RECYCLING BUSINESS OPERATOR**

START

NOTIFY OF RECYCLING OF BATTERY — S30

MANAGE BATTERY ID AND AMOUNT OF CO2 EMISSIONS IN ASSOCIATION WITH EACH OTHER — S31

PROCESSING OF CALCULATING SOH — S32

DECIDE APPORTION RATIO OF AMOUNT OF CO2 EMISSIONS — S33

NOTIFY OF BURDEN SHARE OF AMOUNT OF CO2 EMISSIONS — S34

UPDATE AMOUNT OF CO2 EMISSIONS — S35

END

NOTIFY OF RECYCLING (INCLUDING BATTERY ID)

AMOUNT OF CO2 EMISSIONS

BURDEN SHARE

# FIG. 9

**VEHICLE MANUFACTURER**

START

S40 — READ AMOUNT OF CO2 EMISSIONS

S41 — NOTIFY OF AMOUNT OF CO2 EMISSIONS

S61 — DECIDE APPORTION RATIO OF AMOUNT OF CO2 EMISSIONS

S62 — NOTIFY OF BURDEN SHARE OF AMOUNT OF CO2 EMISSIONS

S43 — UPDATE AMOUNT OF CO2 EMISSIONS

END

**RECYCLING BUSINESS OPERATOR**

START

NOTIFY OF RECYCLING (INCLUDING BATTERY ID)

S30 — NOTIFY OF RECYCLING OF BATTERY

AMOUNT OF CO2 EMISSIONS

S31 — MANAGE BATTERY ID AND AMOUNT OF CO2 EMISSIONS IN ASSOCIATION WITH EACH OTHER

S32 — PROCESSING OF CALCULATING SOH

SOH

S51 — NOTIFY OF SOH

BURDEN SHARE

S52 — ACQUIRE BURDEN SHARE OF AMOUNT OF CO2 EMISSIONS

S35 — UPDATE AMOUNT OF CO2 EMISSIONS

END

Europäisches
Patentamt

European
Patent Office

Office européen
des brevets

**EUROPEAN SEARCH REPORT**

Application Number

EP 22 21 1113

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/019035 A1 (NODA HIDEKI [JP] ET AL) 15 January 2015 (2015-01-15) * paragraph [0025]; claim 8; figure 15 * ----- | 1-9 | INV. G06Q10/30 B60L58/16 G01R31/392 G06Q50/06 H01M10/48 |
| Y | WO 2021/241651 A1 (NTT COMM CORP [JP]) 2 December 2021 (2021-12-02) * claims 5-7; figures 1-6 * & US 2023/084454 A1 (SAKAINO AKIRA [JP] ET AL) 16 March 2023 (2023-03-16) ----- | 1-9 | |
| Y | US 2011/133688 A1 (ISHIBASHI YOSHIHITO [JP]) 9 June 2011 (2011-06-09) * paragraph [0050]; figure 1 * ----- | 1-9 | |

TECHNICAL FIELDS SEARCHED (IPC)

G06Q
B60L
H01M
G01R

The present search report has been drawn up for all claims

| Place of search | Date of completion of the search | Examiner |
|---|---|---|
| Munich | 18 July 2023 | Kerschbaumer, J |

EPO FORM 1503 03.82 (P04C01)

## ANNEX TO THE EUROPEAN SEARCH REPORT
## ON EUROPEAN PATENT APPLICATION NO.

EP 22 21 1113

This annex lists the patent family members relating to the patent documents cited in the above-mentioned European search report.
The members are as contained in the European Patent Office EDP file on
The European Patent Office is in no way liable for these particulars which are merely given for the purpose of information.

18-07-2023

| Patent document cited in search report | | Publication date | Patent family member(s) | | Publication date |
|---|---|---|---|---|---|
| US 2015019035 | A1 | 15-01-2015 | BR 112014018613 | A2 | 20-06-2017 |
| | | | CN 104067476 | A | 24-09-2014 |
| | | | EP 2811608 | A1 | 10-12-2014 |
| | | | JP 5957235 | B2 | 27-07-2016 |
| | | | JP 2013158153 | A | 15-08-2013 |
| | | | MY 167484 | A | 30-08-2018 |
| | | | RU 2014135329 | A | 20-03-2016 |
| | | | US 2015019035 | A1 | 15-01-2015 |
| | | | WO 2013114712 | A1 | 08-08-2013 |
| WO 2021241651 | A1 | 02-12-2021 | CN 115668251 | A | 31-01-2023 |
| | | | EP 4160494 | A1 | 05-04-2023 |
| | | | JP 6972235 | B1 | 24-11-2021 |
| | | | JP 2021189568 | A | 13-12-2021 |
| | | | US 2023084454 | A1 | 16-03-2023 |
| | | | WO 2021241651 | A1 | 02-12-2021 |
| US 2011133688 | A1 | 09-06-2011 | CN 102097833 | A | 15-06-2011 |
| | | | JP 2011125122 | A | 23-06-2011 |
| | | | US 2011133688 | A1 | 09-06-2011 |
| | | | US 2014229028 | A1 | 14-08-2014 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016126372 A